# EUROPÄISCHE PATENTSCHRIFT

(11) **EP 1 199 800 B1**
(45) Veröffentlichungstag und Bekanntmachung des Hinweises auf die Patenterteilung: **29.10.2003**
(21) Anmeldenummer: 01120438.5
(22) Anmeldetag: 27.08.2001
(51) Int. Cl.: H03K 5/13

(54) **Schaltungsanordnung zur Programmierung einer Verzögerungszeit eines Signalpfads**
Circuit for programming the delay time of a signal path
Circuit pour programmer le temps du retard dans une voie du signal

(30) Priorität: 19.10.2000 DE 10051937
(43) Veröffentlichungstag der Anmeldung: 24.04.2002
(73) Patentinhaber: Infineon Technologies AG, 81669 München (DE)
(72) Erfinder: Dietrich, Stefan, Dr., 82299 Türkenfeld (DE); Hein, Thomas, 81379 München (DE); Heyne, Patrick, 81243 München (DE); Markert, Michael, 86152 Augsburg (DE); Marx, Thilo, 78048 Villingen-Schwenningen (DE); Partsch, Torsten, Chapel Hill, NC 27514 (US); Schöniger, Sabine, 83734 Hausham (DE); Schrögmeier, Peter, 81547 München (DE); Sommer, Michael, 81541 München (DE); Weis, Christian, 82110 Germering (DE)
(74) Vertreter: Epping Hermann & Fischer

(56) Entgegenhaltungen:
- DD-A- 288 689
- DE-A- 4 235 317
- US-A- 4 590 388
- PATENT ABSTRACTS OF JAPAN vol. 1996, no. 02, 29. Februar 1996 (1996-02-29) -& JP 07 264021 A (FUJITSU LTD), 13. Oktober 1995 (1995-10-13)

## Beschreibung

Die Erfindung betrifft eine Schaltungsanordnung zur Programmierung einer Verzögerungszeit eines Signalpfads.

In integrierten Schaltungen, insbesondere bei Halbleiterspeichern dynamischer Art, sogenannten DRAMs (Dynamic Random Access Memories) ist es erforderlich, daß dasselbe Schaltungsdesign für verschiedene Anwendungszwecke konfiguriert wird. Außerdem besteht das Erfordernis, funktionelle Eigenschaften in Abhängigkeit von Schwankungen des Herstellungsprozesses einzustellen. Hierzu benutzt man herkömmlicherweise programmierbare Verbindungen, die entweder über eine zusätzliche Metallleiterbahn leitend programmierbar sind oder mittels Energieimpulsen nichtleitend programmierbarer sind, sogenannte Fuses. So können dadurch Verzögerungen von Signalpfaden innerhalb des DRAMs eingestellt werden, oder ein Schaltungsdesign kann auf verschiedene Bausteinvarianten angepaßt werden. Die metallprogrammierbaren oder fusebaren Verbindungen werden als sogenannte Metalloption oder fusebare Option bezeichnet.

Aus der JP-A-7-264021 ist eine Schaltungsanordnung zur Programmierung einer Verzögerungszeit gemäß dem Oberbegriff des Anspruchs 1 bekannt.

In der DE 199 22 712 A1 ist ein Phaseninterpolator mit einer Verzögerungsinterpolationsschaltung gezeigt. Es sind verschiedene Signalpfade gezeigt, deren Verzögerung variabel einstellbar ist. Die Verzögerungszeit wird durch jeweils zugeordnete Ströme unterschiedlicher Stromstärke erreicht. Die Ströme werden von Thermometer-Digital-Analog-Wandlern bereitgestellt.

In der DE 41 12 077 A1 ist ein programmierbarer Logikbaustein gezeigt, bei dem zwischen einer kombinatorischen Verknüpfungsschaltung und der Makrozelle eine Verzögerungsstufe geschaltet ist, deren Verzögerungszeit in Abhängigkeit von einem Steuersignal zwischen zwei Stufen umschaltbar ist.

Die Aufgabe der Erfindung besteht darin, eine Schaltungsanordnung zur Programmierung einer Verzögerungszeit eines Signalpfades anzugeben, die besonders wenig Bauelemente umfaßt und in einfacher Weise programmierbar ist.

Diese Aufgabe wird durch eine Schaltungsanordnung nach Anspruch 1 gelöst.

Die erfindungsgemäße Schaltungsanordnung weist wenige Bauelemente auf. So werden die beiden eine unterschiedliche Signallaufzeit aufweisenden Signalstrecken eingangsseitig parallel angesteuert und erzeugen gemäß ihrer eingestellten Verzögerungszeit je ein Ausgangssignal. Ausgangsseitig wird nur eines der beiden bereitgestellten verzögerten Signale abgegriffen. Hierzu dient der Multiplexer, welcher mittels metall- oder fusebarer Option den einen oder anderen Signalpfad auswählt. Die Auswahlschaltung ist platzsparend. Es sind dort vier metall- oder fusebare Optionen vorgesehen sowie vier Transistoren in je zwei mittig gekoppelten Pfaden. Durch ein voreingestelltes Steuersignal wird eine Einstellung der Ansteuerschaltung ausgewählt und dementsprechend eine Einstellung des Multiplexers. Wesentlich ist, daß nur eine der Optionen pro Pfad leitend programmiert ist, die andere gesperrt ist.

Das die Ansteuerschaltung bedienende Ansteuerungssignal wird zweckmäßigerweise mittels sogenannter Bondoption eingestellt. Hierzu wird das Ansteuersignal von einer Anschlußfläche, sogenanntes Bondpad, abgegriffen, welches mittels einer Bondverbindung an einen Anschluß für den positiven Pol der Versorgungsspannung oder alternativ an einen Anschluß für den negativen Pol der Versorgungsspannung angeschlossen ist. Somit weist das Ansteuerschaltung voreinstellende Signal einen vorgegebenen High-Pegel oder Low-Pegel auf.

Zur Konfiguration wird zuerst mittels der letzten Maske während der Herstellung des Halbleiterchips durch eine Metalloption die Ansteuerschaltung programmiert. Anstelle der Metalloption kann eine fusebare Option durch Aufschmelzen einer Verbindung mittels eines Lasers verwendet werden. Nach dem Test der integrierten Schaltung wird schließlich die exakte gewünschte Verzögerungszeit mittels der Bondoption eingestellt. Es ergibt insgesamt eine flexible Einstellung einer Verzögerungszeit für einen Signalpfad mit Eingriffsmöglichkeit an verschiedenen Stellen des Herstellungsprozesses der integrierten Schaltung.

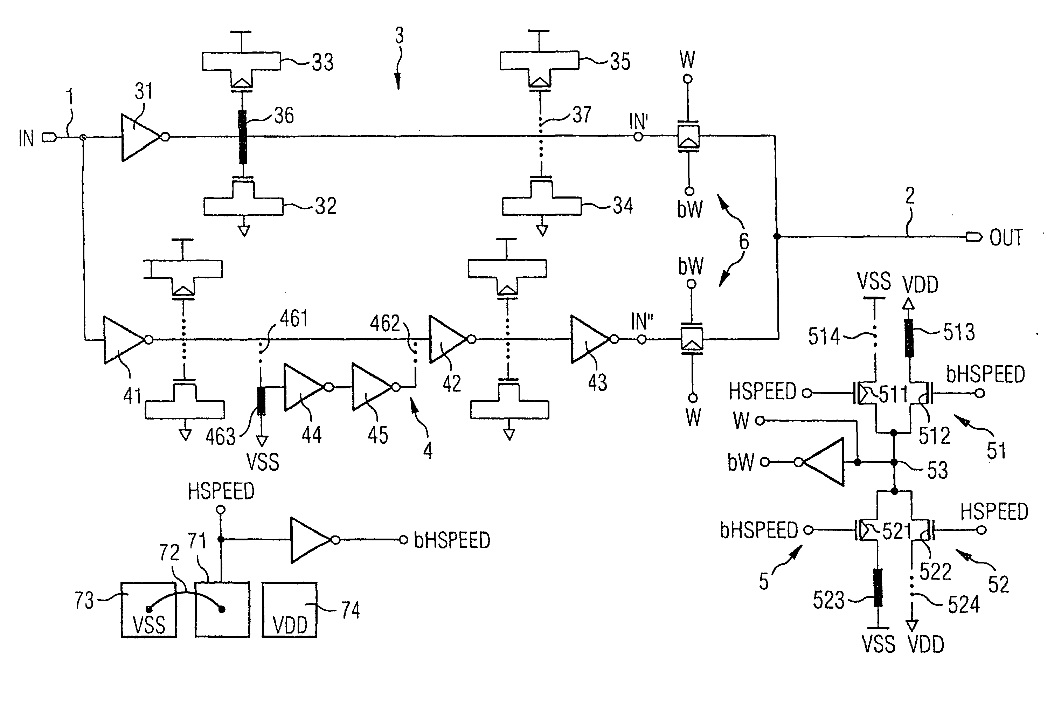

Nachfolgend wird die Erfindung anhand des in der Zeichnung dargestellten Ausführungsbeispiels näher erläutert. Die Figur zeigt einen Ausschnitt von für die Erfindung relevanten Schaltungsdetails eines DRAMs.

Zwischen den Anschlüssen 1 und 2 liegt der Signalpfad, dessen Verzögerungszeit einzustellen ist. Am Anschluß 1 wird ein digitales Eingangsignal IN zugeführt, am Ausgang 2 wird ein entsprechend zeitverzögertes Ausgangssignal OUT abgegriffen. Es sind zwei Signalpfade 3, 4 vorgesehen, die eingangsseitig an den Anschluß 1 angeschlossen sind. Ausgangsseitig sind die Signalpfade 3, 4 mit den Eingangsanschlüssen eines Multiplexers 6 verbunden. Der Multiplexer 6 wird von einem Steuersignal angesteuert, das komplementäre Komponenten W, bW umfaßt. Der Ausgangsanschluß des Multiplexers 6 ist mit dem Ausgang 2 der Schaltung verbunden. Eine Ansteuerschaltung 5 erzeugt das Steuersignal W, bW des Multiplexers.

Die Ansteuerschaltung 5 umfaßt zwei Signalpfade, die zwischen Anschlüsse für die Versorgungsspannung VDD, VSS geschaltet sind und an einem mittleren Knoten gekoppelt sind, um das Signal W bzw. bW bereitzustellen. Die Signalpfade 51, 52 umfassen je einen Transistor 511, 512 bzw. 521, 522, deren Drain-Source-Strecken in Reihe geschaltet sind. Die Source-Anschlüsse der Transistoren sind über eine Metalloption mit dem jeweiligen Anschluß für eines der Versorgungspotentiale VDD, VSS verbunden. Im in der Figur dargestellten Ausführungsbeispiel sind der Transistor 512 über eine eine leitende Verbindung darstellende Metalloption 513 mit dem Anschluß für das Versorgungspotential VDD verbunden, und der Transistor 521 durch eine ebenfalls leitend programmierte Metalloption 523 mit dem Anschluß für das Versorgungspotential VSS. Die anderen Metalloptionen sind nicht programmiert, d.h. gesperrt. So ist der Source-Anschluß des Transistors 522 über die gesperrte, nicht programmierte Metalloption 524 mit dem Anschluß für das positive Versorgungspotential VDD verbunden, der Transistor 511 ist über die gesperrte Metalloption 514 mit dem Anschluß für das negative Versorgungspotential VSS verbunden.

Die Transistoren der Signalpfade 51, 52 sind MOS-Transistoren jeweils komplementären Kanaltyps. Die Transistoren 512, 522 sind n-Kanal-MOS-Transistoren, die Transistoren 511, 521 sind p-Kanal-MOS-Transistoren. Die Transistoren eines der Signalpfade werden von komplementären Komponenten eines Steuersignals angesteuert. Die Transistoren des gleichen Typs von Transistoren (jeweils p- oder jeweils n-Kanal-Transistoren) verschiedener Signalpfade werden ebenfalls von den komplementären Komponenten dieses Steuersignals angesteuert. So werden die Transistoren 521, 512 vom Signal bHSPEED gesteuert, die Transistoren 522, 511 werden vom dazu komplementären Steuersignal HSPEED gesteuert. Durch geeignete Programmierung der programmierbaren Strecken 513, 514, 523, 524 und geeignete Einstellung der Ansteuersignale HSPEED, bHSPEED sind eine Vielzahl von Programmier- und Einstellungsmöglichkeiten gegeben, um das Ansteuersignal W, bW für den Multiplexer 6 zu erzeugen. Es ist entweder nur die Option 513 leitend programmiert und die Option 514 gesperrt oder umgekehrt. Entsprechendes gilt für die Optionen 523 und 524.

Die gezeigten Metalloptionen in der Ansteuerschaltung 5 werden mit dem Aufbringen der letzten Metallebene auf die Schichtstruktur des integrierten Schaltkreises individuallisiert. Alternativ können anstelle von Metalloptionen schmelzbare Fuses vorgesehen sein, die im voreingestellten Zustand leitend sind und mittels eines Energieimpulses, z.B. Laser oder Schmelzstrom, aufgetrennt werden. Allgemein sind die Metalloptionen und Fuses programmierbare Strecken die dauerhaft entweder leitend oder gesperrt eingestellt sind. Das Signal HSPEED bzw. bHSPEED wird anschließend eingestellt, vorzugsweise mittels sogenannter Bondoption. Hierzu ist eine Anschlußfläche 71 vorgesehen, die mittels eines Bonddrahts 72 im gezeigten Ausführungsbeispiel mit einer Anschlußfläche 73 für das Bezugspotential VSS verbunden ist. Alternativ ist es möglich, die Anschlußfläche 71 mit der Anschlußfläche 74 für das positive Versorgungspotential VDD zu verbinden.

Die beiden Signalpfade 3, 4 weisen bezüglich des ihnen am Anschluß 1 eingangsseitig zugeführten Signals IN unterschiedliche Signallaufzeiten auf. Die am Ausgang der Signalstrecken 3, 4 anliegenden verzögerten Signale IN', IN'' werden parallel erzeugt. Anschließend wird durch den Multiplexer 6 eines der Signale ausgewählt und an den Ausgangsanschluß 2 weitergeleitet. Die Signalstrecken 3, 4 weisen eine unterschiedliche Anzahl von bezüglich ihrer Eingangs-/Ausgangs-Signalpfade in Reihe geschaltete Inverter 31 bzw. 41, 42, 43 auf. Darüber hinaus sind metall- oder fusebare Optionen vorgesehen, um an Anschlüsse für die Versorgungsspannung angeschlossene Kondensatoren mit der Signalstrecke 3 bzw. 4 zu verbinden. Dadurch kann für die Signalstrecken 3, 4 eine unterschiedliche Verzögerungszeit eingestellt werden. So sind Kondensatoren 32, 33, 34, 35 vorgesehen, die über eine Metalloption 36 bzw. 37 mit der Signalstrecke verbindbar sind. Die Metalloption 36 ist als Metallleiterbahn leitend programmiert, die Metalloption 37 bleibt im Ausgangszustand gesperrt. Entsprechende Kondensatoren und Metalloptionen sind für die Signalstrecke 4 bereitgestellt. Dort sind die Metalloptionen stets gesperrt. Darüber hinaus ist es vorteilhaft, gegebenenfalls weitere Inverter in die Signalstrecke 4 mittels Metalloption einzuschalten. Vorratsweise sind zwei in Reihe geschaltete Inverter 44, 45 vorgesehen, die über zwei Optionen 461, 462 mit der Signalstrecke 4 verbindbar sind. Im gezeigten Beispiel sind die Metalloptionen 461, 462 gesperrt ausgeführt und statt dessen wird der Eingang des Inverters 44 über eine leitend ausgeführte Metalloption 463 mit dem Anschluß für Bezugspotential VSS verbunden.

Im dargestellten Ausführungsbeispiel weist das Signal HSPEED einen Low-Pegel auf. Das Signal bHSPEED hat einen High-Pegel. Somit ist der Transistor 512 leitend geschaltet und der Transistor 521 ist gesperrt. Das Signal W weist einen High-Pegel auf und wählt im Multiplexer 6 die Signalstrecke 3 aus. Dort wird das Eingangssignal IN durch Invertierung mittels des Inverters 31 und zusätzliche Verzögerung durch die Kondensatoren 32, 33 verzögert an den Ausgangsanschluß 2 als Ausgangssignal OUT weitergeleitet.

Die in der Figur dargestellte Schaltung ist Teil eines Halbleiterspeicherbausteins. Es kann nunmehr der gleiche Halbleiterspeicher für andere Anwendungszwecke konfiguriert werden. Hierzu sind gegebenenfalls die Sicherungen 36, 37, 461, 462, 463 sowie 513, 514, 523, 524 in gewünschter Weise zu programmieren. Die endgültige Einstellung des Multiplexers 6 wird dann durch die Bondoption 71, 72, 73, 74 eingestellt.

## Patentansprüche

1. Schaltungsanordnung zur Programmierung der Verzögerungszeit eines Signalpfads, umfassend:
- einen Eingangsanschluß (1) zur Einspeisung eines Eingangsignals (IN) und einen Ausgangsanschluß (2) zum Abgriff eines Ausgangssignals (OUT),
- eine erste Signalstrecke (3) mit einer ersten Verzögerungszeit und eine zweite Signalstrecke (4) mit einer zweiten, von der ersten verschiedenen Verzögerungszeit, die eingangsseitig mit dem Eingangsanschluß (1) verbunden sind,
- einen Multiplexer (6) der eingangsseitig mit den Signalstrecken (3, 4) verbunden ist und der ausgangsseitig mit dem Ausgangsanschluß (2) zum Abgriff des Ausgangssignals (OUT) verbunden ist, und
- einer Ansteuerschaltung (5), **dadurch gekennzeichnet, daß** die Ansteuerschaltung (5) aufweist:
- einen ersten und einen zweiten zwischen Anschlüsse für eine Versorgungsspannung (VDD, VSS) geschalteten Pfad, die jeweils zwei an einem Knoten (53) gekoppelte Transistoren (511, 512; 521, 522) umfassen sowie eine erste und eine zweite programmierbare Strecke (513, 514; 523, 524),
- wobei die Transistoren von komplementären Steuersignalen (HSPEED, bHSPEED) steuerbar sind und
- wobei die Knoten (53) gemeinsam an einen Steuereingang des Multiplexers (6) angeschlossen sind und nur je eine der programmierbaren Strecken (513, 523) eines Pfades leitend, die andere der programmierbaren Strecken (514, 524) unterbrochen programmiert ist.

2. Schaltungsanordnung nach Anspruch 1,
**dadurch gekennzeichnet, daß**
die programmierbaren Strecken (513, 514, 523, 524) zwischen einen Source-Anschluß eines der Transistoren (511, 512, 521, 522) und einen Anschluß für die Versorgungsspannung (VDD, VSS) geschaltet sind.

3. Schaltungsanordnung nach Anspruch 1 oder 2,
**dadurch gekennzeichnet, daß**
die komplementären Steuersignale (HSPEED, bHSPEED) durch eine Anschlußfläche (71) erzeugbar sind, die durch einen Bonddraht (72) mit einer weiteren Anschlußfläche (73) zur Einspeisung eines Pols der Versorgungsspannung (VDD, VSS) verbunden ist.

4. Schaltungsanordnung nach einem der Ansprüche 1 bis 3,
**dadurch gekennzeichnet, daß**
die Signalstrecken (3, 4) verschiedene Anzahl von in Reihe geschalteten Invertern (31; 41, 42, 43; 44, 45) umfassen.

5. Schaltungsanordnung nach einem der Ansprüche 1 bis 4,
**dadurch gekennzeichnet, daß**
die Signalstrecken (3, 4) Kondensatoren (32, 33, 34, 35) umfassen, die mit der jeweiligen der Signalstrecken (3, 4) über programmierbare Strecken (36, 37) verbindbar sind.

6. Schaltungsanordnung nach einem der Ansprüche 1 bis 5,
**dadurch gekennzeichnet, daß**
die Transistoren n-Kanal-MOS-Transistoren (512, 522) und dazu komplementäre p-Kanal-MOS-Transistoren (511, 521) umfassen.

7. Schaltungsanordnung nach einem der Ansprüche 1 bis 6,
**dadurch gekennzeichnet, daß**
die programmierbaren Strecken (513, 514, 523, 524, 36, 37) einen ersten und einen zweiten Anschluß umfassen, die in gesperrten Zustand unverbunden sind und die im leitend programmierten Zustand mit einer Metallleitung (513, 523, 36) verbunden sind.

## Claims

1. Circuit arrangement for programming the delay of a signal path, comprising:
- an input terminal (1) for feeding in an input signal (IN) and an output terminal (2) for tapping an output signal (OUT),
- a first signal path section (3) with a first delay and a second signal path section (4) with a second delay, different from the first, which signal path sections (3, 4) are connected to the input terminal (1) at the input end,
- a multiplexer (6) which is connected to the signal path sections (3, 4) at the input end and which is connected to the output terminal (2) at the output end in order to tap the output signal (OUT), and
- a drive circuit (5), **characterized in that** the drive circuit (5) has:
- a first and a second path, which paths are connected between terminals for a supply voltage (VDD, VSS) and which each comprise two transistors (511, 512; 521, 522) which are coupled to a node (53) and a first and a second programmable path section (513, 514; 523, 524),
- the transistors being controllable by complementary control signals (HSPEED, bHSPEED) and
- the nodes (53) being both connected to a control input of the multiplexer (6) and in each case just one of the programmable sections (513, 523) of a path being programmed to be switched on and the other of the programmable path sections (514, 524) being programmed to be switched off.

2. Circuit arrangement according to Claim 1, **characterized in that** the programmable path sections (513, 514, 523, 524) are connected between a source terminal of one of the transistors (511, 512, 521, 522) and a terminal for the supply voltage (VDD, VSS).

3. Circuit arrangement according to Claim 1 or 2, **characterized in that** the complementary control signals (HSPEED, bHSPEED) can be generated by means of a terminal face (71) which is connected by means of a bonding wire (72) to a further terminal face (73) for feeding in a pole for the supply voltage VDD, VSS).

4. Circuit arrangement according to one of Claims 1 to 3, **characterized in that** the signal path sections (3, 4) comprise a different number of inverters (31; 41, 42, 43; 44, 45) which are connected in series.

5. Circuit arrangement according to one of Claims 1 to 4, **characterized in that** the signal path sections (3, 4) comprise capacitors (32, 33, 34, 35) which can be connected to those of the signal path sections (3, 4) via programmable path sections (36, 37).

6. Circuit arrangement according to one of Claims 1 to 5, **characterized in that** the transistors comprise n-type channel MOS transistors (512, 522) and p-type channel MOS transistors (511, 521) which are complementary thereto.

7. Circuit arrangement according to one of Claims 1 to 6, **characterized in that** the programmable path sections 513, 514, 523, 524, 36, 37) comprise a first and a second terminal which are not connected in the switched off state and which are connected to a metal line (513, 523, 36) in the state in which it is programmed to be switched on.

## Revendications

1. Circuit de programmation du temps de retard dans une voie de signal, comprenant :
- une borne (1) d'entrée d'envoi d'un signal (IN) d'entrée et une borne (2) de sortie de prélèvement d'un signal (OUT) de sortie,
- une première section (3) de signal ayant un premier temps de retard et une deuxième section (4) de signal ayant un deuxième temps de retard qui est différent du premier, qui sont reliées du côté de l'entrée à la borne (1) d'entrée,
- un multiplexeur (6) qui est relié du côté de l'entrée aux sections (3, 4) de signal et qui est relié du côté de la sortie à la borne (2) de sortie pour le prélèvement du signal (OUT) de sortie, et
- un circuit (5) de commande, **caractérisé en ce que** le circuit (5) de commande comporte
- une première voie et une deuxième voie montées entre des bornes pour une tension (VDD, VSS) d'alimentation, qui comprennent respectivement deux transistors (511, 512 ; 521, 522) couplés à un noeud (53) ainsi qu'une première et une seconde section (513, 514 ; 523, 524) programmable,
- les transistors pouvant être commandés par des signaux (HSPEED, bHSPEED) complémentaires de commande, et
- les noeuds (53) étant reliés en commun à une entrée de commande du multiplexeur (6) et seule l'une des sections (513, 523) programmables d'une voie étant programmée conductrice, tandis que l'autre des sections (514, 524) programmables est programmée interrompue.

2. Circuit de programmation selon la revendication 1, **caractérisé en ce que** les sections (513, 514 ; 523, 524) programmables sont montées entre une borne de source de l'un des transistors (511, 512 ; 521, 522) et une borne pour la tension (VDD, VSS) d'alimentation.

3. Circuit suivant la revendication 1 ou 2, **caractérisé en ce que** les signaux (HSPEED, bHSPEED) complémentaires de commande peuvent être produits par une surface (71) de raccordement, qui est reliée par l'intermédiaire d'un fil (72) de liaison à une surface (73) de raccordement supplémentaire pour l'alimentation d'un pôle de la tension (VDD, VSS) d'alimentation.

4. Circuit suivant l'une des revendications 1 à 3, **caractérisé en ce que** les sections (3, 4) de signal comportent des nombres différents d'inverseurs (31 ; 41, 42, 43 ; 44, 45) montés en série.

5. Circuit suivant l'une des revendications 1 à 4, **caractérisé en ce que** les sections (3, 4) de signal comportent des condensateurs (32, 33, 34, 35), qui peuvent être reliés avec les sections (3, 4) de signal respectives par l'intermédiaire de sections (36, 37) pouvant être programmées.

6. Circuit suivant l'une des revendications 1 à 5, **caractérisé en ce que** les transistors comportent des transistors (512, 522) MOS de canal n et des transistors (511, 521) MOS de canal p complémentaires à ceux-là.

7. Circuit suivant l'une des revendications 1 à 6, **caractérisé en ce que** les sections (513, 514, 523, 524, 36, 37) pouvant être programmées comportent une première borne et une deuxième borne, qui peuvent être sorties de leur liaison à l'état bloqué et qui à l'état programmé conducteur sont reliés par un conducteur (513, 523, 36) métallique.
